# EUROPEAN PATENT SPECIFICATION

(11) **EP 3 971 681 B1**
(45) Date of publication and mention of the grant of the patent: **19.06.2024**
(21) Application number: 20815643.0
(22) Date of filing: 25.05.2020
(51) Int. Cl.: G06F 1/20, H05K 7/20, F28D 15/04, F28F 3/12, F28D 15/02, F28D 21/00

(54) **HEAT-CONDUCTING MEMBER AND ELECTRONIC DEVICE**
WÄRMELEITENDES ELEMENT UND ELEKTRONISCHE VORRICHTUNG
ÉLÉMENT THERMOCONDUCTEUR ET DISPOSITIF ÉLECTRONIQUE

(30) Priority: 29.05.2019 CN 201910456489
(43) Date of publication of application: 23.03.2022
(73) Proprietor: Huawei Technologies Co., Ltd., Longgang District Shenzhen, Guangdong 518129 (CN)
(72) Inventor: LI, Longyu, Shenzhen, Guangdong 518129 (CN); CAI, Ming, Shenzhen, Guangdong 518129 (CN); HUANG, Xuelong, Shenzhen, Guangdong 518129 (CN)
(74) Representative: Maiwald GmbH
(86) International application number: PCT/CN2020/092170
(87) International publication number: WO 2020/238865

(56) References cited:
- EP-A1- 1 335 172
- JP-A- H11 304 381
- JP-A- 2002 022 378
- US-A1- 2007 012 429
- US-A1- 2009 260 785
- US-A1- 2018 361 505

## Description

### TECHNICAL FIELD

This application relates to the field of electronic device technologies, and in particular, to a heat conducting part and an electronic device.

### BACKGROUND

Electronic components (such as a processor and a display card) in an electronic device generate a large amount of heat during operation. To ensure normal operation of the electronic device, a heat pipe, a vapor chamber, a fan, and the like are usually disposed in the electronic device to dissipate heat of the electronic components.

The vapor chamber is a vacuum cavity with a fine structure on an inner wall and is usually made of copper. Water is injected into the vacuum cavity to serve as cooling liquid. When heat is conducted to an evaporation area from a heat source, the cooling liquid in the cavity starts to be gasified after being heated in a low-vacuum-degree environment. At this moment, heat energy is absorbed, the volume is rapidly expanded, and the whole cavity is rapidly filled with a gas-phase cooling medium. When the gas-phase working medium comes into contact with a cold area, a condensation phenomenon is resulted, heat accumulated during evaporation is released, and the condensed cooling liquid returns to the heat source through the fine structure. In this way, heat conduction is implemented in cycles.

A conventional vapor chamber is made of copper, and therefore the vapor chamber has the disadvantage of a heavy weight, which is unfavorable for a lightweight design of the vapor chamber and the electronic device.

A structure of a conventional heat pipe is similar to that of the vapor chamber, and the conventional heat pipe is also made of copper. Therefore, the heat pipe also has the disadvantage of a heavy weight, which is unfavorable for implementing the lightweight design of the vapor chamber and the electronic device.

JP H11 30 4381 A describes a heat pipe with a coating layer of a material having corrosion resistance.

JP 2002 022378 A describes a heat pipe comprising a clad material in which a copper-based material and an aluminium-based material are joined according to the preamble of claim 1.

US 2009/260785 A1 describes a heat plate with capillary support structure.

### SUMMARY

This application provides a heat conducting part with a relatively light weight and a long service life, and an electronic device.

The present invention is defined by the subject-matter of the independent claims. Additional features of the invention are presented in the dependent claims.

### BRIEF DESCRIPTION OF DRAWINGS

FIG. 1 is a schematic structural diagram of a shell of a heat conducting part according to an embodiment of this application;
FIG. 2 is an exploded view of a shell of a heat conducting part according to an embodiment of this application;
FIG 3 is a schematic cross-sectional structural diagram of a shell of a heat conducting part according to an embodiment of this application;
FIG 4 is a schematic cross-sectional structural diagram of a shell of another heat conducting part according to an embodiment of this application;
FIG 5 is an exploded view of a first visual angle of a first plate body according to an embodiment of this application;
FIG 6 is an exploded view of a second visual angle of a first plate body according to an embodiment of this application;
FIG 7 is an exploded view of another first plate body according to an embodiment of this application;
FIG 8 is a schematic cross-sectional structural diagram of a shell of still another heat conducting part according to an embodiment of this application;
FIG 9 is a schematic cross-sectional structural diagram of a shell of still another heat conducting part according to an embodiment of this application;
FIG 10 is a schematic cross-sectional structural diagram of a supporting column according to an embodiment of this application;
FIG 11 is a schematic cross-sectional structural diagram of another supporting column according to an embodiment of this application;
FIG. 12 is a schematic structural diagram of still another supporting column according to an embodiment of this application;
FIG. 13 is a schematic structural diagram of a supporting column installed on a first plate body according to an embodiment of this application;
FIG. 14 is a schematic structural diagram of a first plate body according to an embodiment of this application;
FIG. 15 is a schematic cross-sectional structural diagram of a first plate body according to an embodiment of this application;
FIG. 16 is a schematic cross-sectional structural diagram of a heat conducting part according to an embodiment of this application;
FIG. 17 is a schematic structural diagram of another heat conducting part according to an embodiment of this application;
FIG. 18 is a schematic cross-sectional structural diagram of another heat conducting part according to an embodiment of this application;
FIG. 19 is a schematic cross-sectional structural diagram of still another heat conducting part according to an embodiment of this application; and
FIG. 20 is a schematic structural diagram of an electronic device according to an embodiment of this application.

### DESCRIPTION OF EMBODIMENTS

To make the objectives, technical solutions, and advantages of this application clearer, the following further describes this application in detail with reference to the accompanying drawings.

Terms used in the following embodiments are merely intended for a purpose of describing a particular embodiment, and are not intended to limit this application. As used in the specification of this application and the appended claims, singular expressions such as "a", "an", "foregoing", "the", and "this" are intended to include such expression as "one or more", unless otherwise expressly specified in the context. It should also be understood that "at least one" and "one or more" in the following embodiments of this application refer to one, two, or more than two. The term "and/or" is used for describing an association relationship between associated objects, and indicates that three relationships may exist. For example, A and/or B may indicate the following three conditions: A exists alone, both A and B exist, and B exists alone, where A and B may be singular or plural. The character "/" generally indicates an "or" relationship between the associated objects.

Reference to "one embodiment", "some embodiments", or the like described in the specification means that a particular feature, structure, or characteristic described in combination with the embodiment is included in one or more embodiments of this application. Therefore, phrases such as "in one embodiment", "in some embodiments", "in other embodiments", and "in some other embodiments" in various places of this specification do not necessarily all refer to the same embodiment, but rather mean "one or more, but not all, embodiments", unless otherwise specifically emphasized. The terms such as "include", "comprise", "have", and variations thereof all mean "include but not limited to", unless otherwise specifically emphasized.

For ease of understanding of the heat conducting part provided in the embodiments of this application, an application scenario of the heat conducting part is described below. The heat conducting part provided in this application is applied to an electronic device and is used for conducting and diffusing heat generated by a heating element in the electronic device, so as to achieve a purpose of heat dissipation. The electronic device may be specifically a mobile phone, a tablet computer, a notebook computer, or the like.

Using an example in which the electronic device is a notebook computer, main heating elements in the notebook computer generally include a processor (central processing unit, CPU), a display chip (video chipset, GPU), and the like. A large amount of heat is generated when the processor or the display chip runs. Therefore, in order to prevent working performance of the processor or the display chip from being affected by an excessively high temperature, a heat pipe, a vapor chamber, or the like is disposed in the notebook computer to serve as a heat conducting part and used for dissipating heat of the processor or the display chip.

The whole vapor chamber is a plate-shaped structure and mainly includes two cover plates mutually sealed. A closed cavity is formed between the two cover plates, any one or a combination of a copper net, copper fiber, sintered copper powder, and a copper felt is disposed inside the cavity to serve as a capillary structure, and the cavity is filled with pure water to serve as cooling liquid. In order to prevent the cover plates from being eroded by the cooling liquid, the two cover plates are usually made of oxygen-free copper. The working principle of the vapor chamber mainly includes four main steps of conduction, evaporation, convection and condensation. Specifically, in the vapor chamber, after being heated, water close to a heat source (for example, one cover plate) rapidly absorbs heat and is gasified to form water vapor, the water vapor is diffused in the cavity and when the water vapor approaches a cold source (for example, the other cover plate), the water vapor can be rapidly condensed into liquid and release heat. Condensed water flows back to the heat source through the capillary structure, and a heat conduction cycle is completed.

However, the two cover plates are both made of oxygen-free copper, and a relatively large density of the copper results in a relatively large weight of the whole vapor chamber, which is unfavorable for a lightweight design of the electronic device. Such disadvantage becomes more obvious for a portable electronic device, reducing portability of the electronic device and also degrading user experience.

A working principle of the heat pipe is similar to that of the vapor chamber. The whole heat pipe is of a long-strip-shaped tubular structure, and the heat pipe has a closed cavity. A capillary structure tightly attached to an inner wall is also disposed in the cavity, and the cavity is filled with water, ethyl alcohol, or a mixed solution of the water and the ethyl alcohol to serve as cooling liquid. In order to prevent a pipe body of the heat pipe from being eroded by water, the heat pipe is usually made of copper. A relatively large density of the copper results in a relatively large weight of the whole heat pipe, which is unfavorable for the lightweight design of the electronic device. Such disadvantage becomes more obvious for a portable electronic device, reducing portability of the electronic device and also degrading user experience.

In view of this, an embodiment of this application provides a heat conducting part with a light weight, a long service life, and a high structural strength.

The heat conducting part provided in this embodiment of this application includes a shell, a capillary structure, and cooling liquid. The shell includes an inner layer and an outer layer, where a cavity is enclosed by the inner layer, and the outer layer wraps a periphery of the inner layer. The capillary structure is disposed in the cavity and abuts against the shell. The cooling liquid is located in the cavity. The inner layer and the outer layer are made of different materials, and a material density of the outer layer is lower than a material density of the inner layer.

During specific implementation, the inner layer is made of copper or copper alloy; and the outer layer is made of aluminum, titanium, aluminum alloy, titanium alloy, or the like. In addition, a thickness ratio of the inner layer to the outer layer may be 1:1, 1:2, 2:1, or the like. That is, a thickness of the inner layer may be greater than, equal to, or less than a thickness of the outer layer; or an overall thickness of the inner layer may be the same or different; and correspondingly, an overall thickness of the outer layer may be the same or different.

With disposition of the foregoing structure, a material with a relatively large density and a stable chemical property may be selected for the inner layer to ensure durability of the heat conducting part; and a material with a relatively small density may be selected for the outer layer to ensure a structural strength of the shell and reduce an overall weight of the shell, or a material with better heat conducting performance is selected to improve the heat conducting performance of the heat conducting part. Combining the inner layer and the outer layer can not only ensure working stability of the heat conducting part, but also ensure the structural strength of the heat conducting part, to avoid damages caused by external force. In addition, the weight of the shell is effectively reduced, which is conducive to a lightweight design.

During specific implementation, the overall structure of the shell may be in a variety of forms, for example, may be plate-shaped, tubular, or in other shapes.

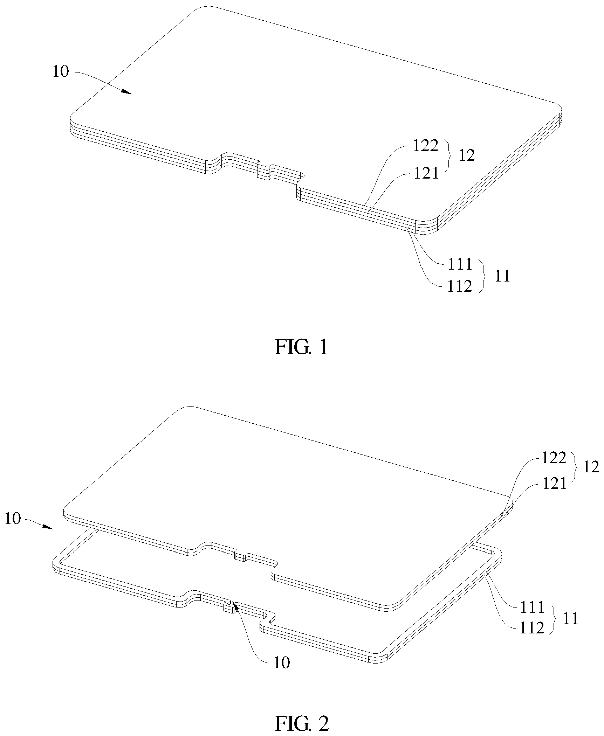

As shown in FIG. 1, in one embodiment provided in this application, the shell is of a plate-shaped structure.

According to the the shell is formed by buckling two plate bodies. Referring to FIG. 2, specifically, the shell includes a first plate body 11 and a second plate body 12 that are buckled to each other, and the first plate body 11 and the second plate body 12 are buckled to each other to form the cavity. With disposition of such a structure, a manufacturing difficulty of the shell can be reduced, which helps reduce manufacturing costs. In addition, manufacturing quality of the shell can be ensured, thereby helping improve the working stability and the service life of the heat conducting part.

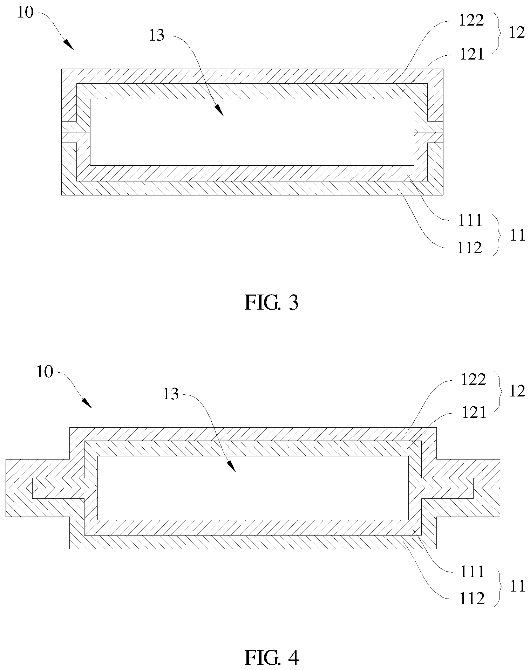

As shown in FIG. 3, the first plate body 11 and the second plate body 12 each are provided with the inner layer and the outer layer. Specifically, when the first plate body 11 and the second plate body 12 are buckled to each other, an edge of an inner layer 111 in the first plate body 11 is tightly fitted to an edge of an inner layer 121 in the second plate body 12, so as to form a closed cavity 13. Certainly, as shown in FIG. 4, in another embodiment provided in this application, when the edge of the inner layer 111 is tightly fitted to the edge of the inner layer 121, the edge of the outer layer 112 in the first plate body 11 may be tightly fitted to the edge of the outer layer 122 in the second plate body 12.

The inner layers and the outer layers in the first plate body and the second plate body may have various types of structures and manufacturing processes.

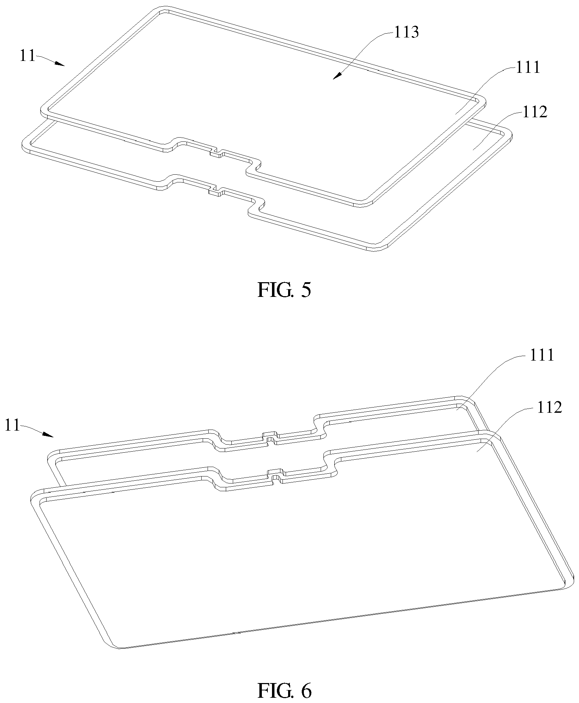

Using the first plate body as an example, as shown in FIG. 5, in one embodiment provided in this application, the inner layer 111 and the outer layer 112 in the first plate body 11 may be two separate plates.

In a specific implementation, the inner layer 111 and the outer layer 112 of the first plate body 11 may be separately formed and then combined. Specifically, the inner layer 111 may use a flat plate as a blank, and punching and cutting are performed on the blank according to needs, to obtain a formed inner layer. The outer layer 112 may use a flat plate as a blank, and punching and cutting are performed on the blank according to needs, to obtain a formed outer layer. Then, the formed inner layer and the formed outer layer are combined through processes such as pressing (hot pressing or cold pressing) or welding, so as to complete preparation of the first plate body 11.

In another specific implementation, the inner layer 111 and the outer layer 112 may be first combined, and the first plate body 11 is then formed. Specifically, the inner layer 111 may use a flat plate as a blank and the outer layer 112 may also use a flat plate as a blank; the blank of the inner layer and the blank of the outer layer are combined through processes such as pressing (hot pressing or cold pressing) or welding, so as to obtain a preformed first plate body; and then punching and cutting are performed on the preformed first plate body according to needs, to complete preparation of the first plate body 11.

The cavity in the shell is formed by buckling the first plate body 11 and the second plate body 12, and therefore the inner layer of the first plate body and/or the inner layer of the second plate body are provided with a concave cavity structure, so as to form the cavity after the first plate body and the second plate body are buckled to each other.

The concave cavity may be specifically formed in a variety of manners, for example, being formed in a punching manner or being formed in an etching and milling manner.

As shown in FIG. 5 and FIG. 6, in one embodiment provided in this application, a concave cavity 113 in the first plate body 11 is formed in the punching manner. In a specific implementation, the inner layer 111 and the outer layer 112 in the first plate body 11 may be punched separately, and then the inner layer 111 and the outer layer 112 that are formed by punching are combined, so as to complete preparation of the first plate body 11. In another implementation, the inner layer 111 and the outer layer 112 in the first plate body 11 may be first combined, and the first plate body 11 is then punched by using a punching process to form the concave cavity 113.

Certainly, in other embodiments, the inner layer and the outer layer in the first plate body may be alternatively not two separate plates.

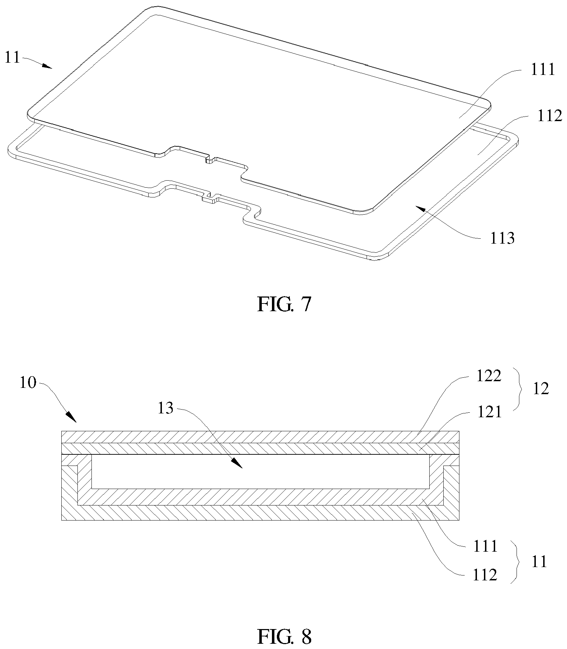

For example, as shown in FIG. 7, in one embodiment provided in this application, the outer layer 112 of the first plate body 11 is a plate, and the inner layer 111 is directly formed on a surface of the outer layer 112 by using electroplating, vapor deposition, or other processes.

During specific implementation, the outer layer 112 may be treated by using processes such as punching, etching, and milling to form the concave cavity 113, and then the inner layer may be directly formed on a side of the concave cavity of the outer layer 112 in a manner such as electroplating or vapor deposition.

A specific structure and manufacturing process of the second plate body may be roughly the same as those of the first plate body. A first plate body and a second plate body in a same shell may have substantially the same or different specific structures and manufacturing processes.

For example, as shown in FIG. 3, in one embodiment, the first plate and the second plate body in the shell may have a substantially same structure. Specifically, the first plate body 11 and the second plate body 12 each are provided with a concave cavity structure, and after the first plate body 11 and the second plate body 12 are buckled to each other, the concave cavity structure located on the first plate body 11 and the concave cavity structure located on the second plate body 12 are buckled to each other to form the cavity 13.

Certainly, in another implementation, the structures of the first plate and the second plate body in the shell may be different. As shown in FIG. 8, according to an example not within the scope of the invention, the first plate body 11 is provided with a concave cavity structure, and the second plate body 12 is provided with no concave cavity structure. After the first plate body 11 and the second plate body 12 are buckled to each other, the concave cavity structure located in the first plate body 11 is buckled to the concave cavity structure located in the second plate body 12 to form the cavity 13.

In addition, in order to improve the structural strength of the heat conducting part, in this embodiment provided in this application, the heat conducting part further includes at least one supporting column. The supporting column is disposed in the cavity and configured to support the cavity and prevent the cavity from being deformed by force and becoming smaller.

During specific implementation, the supporting column may be an independent structural part or may be a structure integrally formed with the first plate body or the second plate body in the shell.

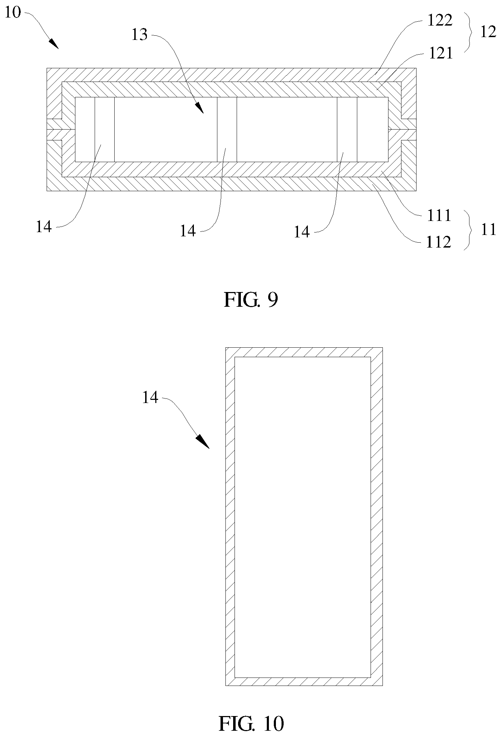

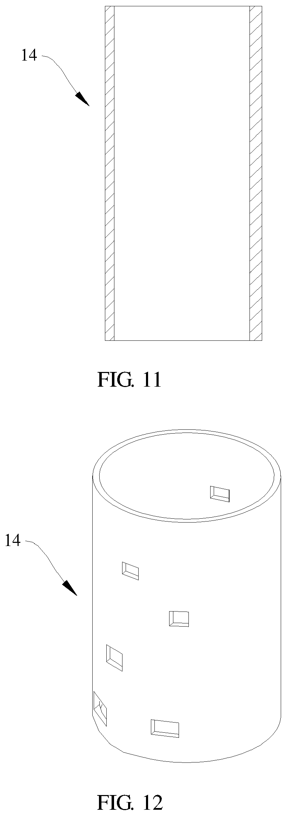

As shown in FIG. 9, in one embodiment provided in this application, the supporting column 14 is an independent structural part; and one end of the supporting column 14 abuts against the first plate body 11, and the other end of the supporting column 14 abuts against the second plate body 12. In order to reduce a weight of the supporting column 14, as shown in FIG. 10, the supporting column 14 may be a hollow structure with two closed ends; or as shown in FIG. 11, the supporting column 14 may be a tubular structure. In some embodiments, in order to prevent the cooling liquid from accumulating inside the supporting column 14, as shown in FIG. 12, a peripheral surface of the supporting column 14 may be further provided in a hollowed-out shape. Certainly, in other implementations, the inner wall or outer wall of the supporting column 14 may be further provided with a capillary structure, so as to implement backflow of the cooling liquid by using the capillary structure located on the supporting column 14. During specific implementation, the capillary structure may be a long-strip-shaped groove or a long-strip-shaped protruding edge provided in the length direction of the supporting column.

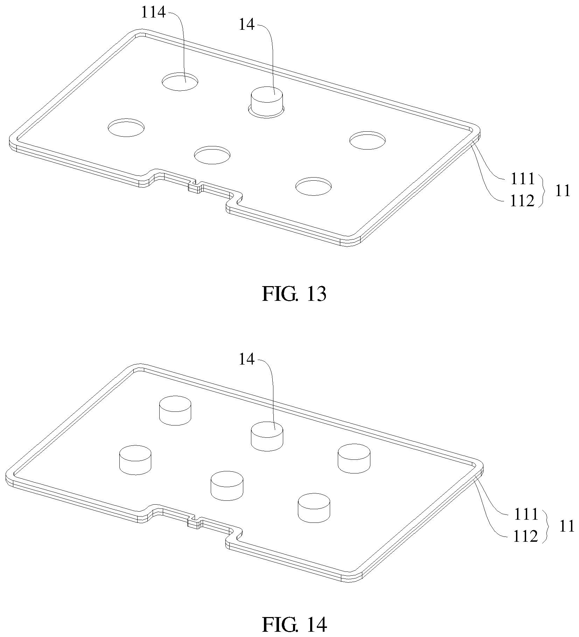

When the supporting column is installed in the shell, in order to prevent position deviation between the supporting column and the shell, as shown in FIG. 13, in one embodiment provided in this application, a locating slot 114 is provided in the first plate body 11, where a profile of the locating slot 114 may be slightly greater than or equal to a peripheral profile of the supporting column 14, or the profile of the locating slot 114 may be slightly less than the peripheral profile of the supporting column 14, so as to implement an interference fit between the locating slot 114 and the supporting column 14. In the assembly process, the first plate body 11 may be horizontally placed with the inner layer 111 of the first plate body 11 facing upwards; a lower end of the supporting column 14 is inserted into the locating slot 114; the capillary structure is placed; and finally the first plate body and the second plate body are buckled, so that an upper end of the supporting column abuts against the inner layer of the second plate body.

Certainly, in other specific implementations, a locating slot is also provided in the second plate body, or locating slots are provided in both the first plate body and the second plate body, so as to improve a locating precision and connection stability between the supporting column and the shell.

In addition, in some specific implementations, the supporting column may alternatively be connected to the shell. During specific implementation, one end of the supporting column may be connected to the first plate body, and the other end of the supporting column may abut against the second plate body. Alternatively, one end of the supporting column may be connected to the second plate body, and the other end of the supporting column may abut against the first plate body. The supporting column may be connected to the first plate body or the second plate body in a welding or inserting manner.

Certainly, in other specific implementations, the supporting column may alternatively be a structure integrally formed with the shell. Specifically, the supporting column may be a structure integrally formed with the first plate body, or may be a structure integrally formed with the second plate body.

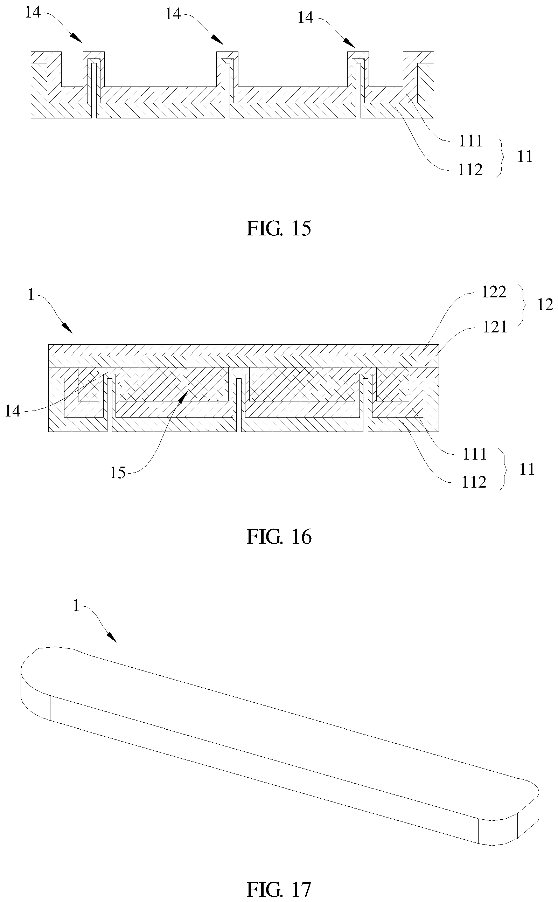

As shown in FIG. 14 and FIG 15, in one embodiment provided in this application, the supporting column 14 is a structure integrally formed with the first plate body 11. During specific implementation, the first plate body 11 may be treated by using a punching process to form the supporting column 14. After the first plate body and the second plate body are buckled to each other, an extending end of the supporting column 14 abuts against the inner layer of the second plate body.

Certainly, the capillary structure needs to be installed between the first plate body and the second plate body before the first plate body and the second plate body are buckled.

During assembly of all components of the heat conducting part, a proper assembling manner may be selected based on the specific structures of the first plate body and the second plate body.

For example, as shown in FIG 16, when the supporting column 14 is a structure integrally formed with the first plate body 11, the capillary structure 15 may be placed on the first plate body 11 and abuts against the inner layer 111 of the first plate body 11; and then the second plate body 12 and the first plate body 11 are buckled tightly. The first plate body 11 and the second plate body 12 may be connected in a manner of welding, press-fit, or the like. Certainly, to facilitate processes of vacuumizing the cavity, injecting the cooling liquid, and the like, referring to FIG. 2, after the first plate body 11 and the second plate body 12 are buckled tightly, an opening 115 communicating with the cavity should be reserved. During the vacuumizing process, gas in the cavity may be pumped out through the opening 115, so that the cavity is in a negative pressure state. In addition, the cooling liquid may be injected into the cavity through the opening 115. After the processes of vacuumizing and cooling liquid injection are completed, the opening 115 is sealed.

During specific implementation, the capillary structure 15 may be any one or a combination of a copper net, copper fiber, sintered copper powder and a copper felt. The capillary structure may be placed in the cavity and abuts against the first plate body 11 and the second plate body 12; or the capillary structure 15 is fixedly connected to the first plate body 11 and/or the second plate body 12.

During specific application of the heat conducting part 1 of the plate-shaped structure in the foregoing embodiments, one plate surface is disposed close to the heat source or conductively comes in contact with the heat source. Specifically, referring to FIG. 16, the first plate body 11 may be tightly close to the heat source or conductively come in contact with the heat source through heat-conducting silicone grease to implement fixed connection between the heat conducting part 1 and the heat source. In this case, an evaporation area is formed on one side of the first plate body 11, and a condensation area is formed on one side of the second plate body 12. When heat is conducted to the evaporation area from the heat source, the cooling liquid (a liquid cooling medium) in the cavity starts to be gasified after being heated in a low-vacuum-degree environment, and the whole cavity is rapidly filled with the gasified cooling medium. When a gas-phase working medium comes in contact with the condensation area, the condensation phenomenon is resulted, and heat is released. The condensed cooling liquid flows back to the evaporation area through the capillary structure 15. In this way, heat conduction and dissipation is implemented in cycles.

When the heat conducting part is a long-strip-shaped tubular structure shown in FIG 17, one end of the heat conducting part conductively comes in contact with the heat source to serve as the evaporation area, and the other end serves as the condensation area.

During specific application of the heat conducting part 1 of the long-strip-shaped tubular structure, one end of the heat conducting part 1 is disposed close to the heat source or conductively comes in contact with the heat source. Specifically, the one end of the heat conducting part may be tightly close to the heat source or conductively come in contact with the heat source through heat-conducting silicone grease to implement fixed connection between the heat conducting part and the heat source. In this case, an evaporation area is formed at one end close to the heat source, and a condensation area is formed at the other end. When heat is conducted to the evaporation area from the heat source, the cooling liquid (a liquid cooling medium) in the cavity starts to be gasified after being heated in a low-vacuum-degree environment, and the whole cavity is rapidly filled with the gasified cooling medium. When a gas-phase working medium comes in contact with the condensation area, the condensation phenomenon is resulted, and heat is released. The condensed cooling liquid flows back to the evaporation area through the capillary structure. In this way, heat conduction and dissipation is implemented in cycles.

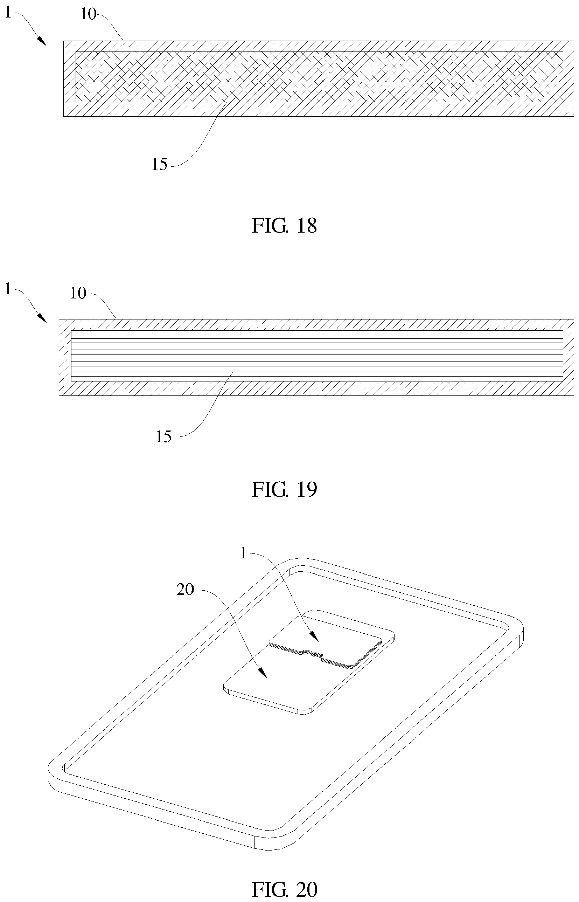

As shown in FIG. 18, the capillary structure may be specifically a mesh structure similar to that in the embodiment described above, so that the cooling liquid flows back from the condensation area to the evaporation area of the heat conducting part. Certainly, in some implementations, the capillary structure may alternatively be formed on a wall of the cavity.

As shown in FIG. 19, in one embodiment provided in this application, the capillary structure 15 is disposed on the inner wall of the cavity. During specific implementation, the capillary structure 15 may be a structure capable of generating capillarity, such as a microgroove or a microprotrusion.

In addition, as shown in FIG. 20, an embodiment of this application further provides an electronic device, including an electric element 20 and the heat conducting part 1 in any one of the foregoing embodiments, where the heat conducting part 1 is conductively connected to the electric element 20. Specifically, the electronic device further includes components such as a circuit board, a power supply module, and a screen. The electric element 20 may be installed on the circuit board and is configured to implement signal connection with other electric elements in the electronic device. The power supply module may supply or transmit electric energy to the electric element 20. The heat conducting part 1 may abut against the electric element 20, or is conductively connected to the electric element through an auxiliary material such as heat conducting silicone grease, so that heat generated by the electric element can be effectively transferred to the heat conducting part.

During specific implementation, the electronic device may be a tablet computer, a notebook computer, a mobile phone, or the like. The electric element may be a CPU, a GPU, or the like.

In addition, in some specific implementations, the electronic device may be further provided with a fan, heat dissipation fins, and the like to dissipate heat for the heat conducting part, so as to improve heat dissipation effect of the electric element.

The foregoing descriptions are merely specific implementations of this application, but are not intended to limit the protection scope of this application. Therefore, the protection scope of this application shall be subject to the protection scope of the claims.

## Claims

1. A heat conducting part, comprising:
a shell, comprising an inner layer (111, 121) and an outer layer (112, 122), wherein a cavity (13) is enclosed by the inner layer (111, 121), and the outer layer (112, 122) wraps a periphery of the inner layer (111, 121);
a capillary structure, disposed in the cavity (13) and abutting against the shell; and
cooling liquid, located in the cavity (13), wherein
the inner layer (111, 121) and the outer layer (112, 122) are made of different materials, and a material density of the outer layer (112, 122) is lower than a material density of the inner layer (111, 121);
wherein the shell comprises a first plate body (11) and a second plate body (12) that are buckled to each other; and
the inner layer (111, 121) is located on each of plate surfaces, facing towards each other, of the first plate body (11) and the second plate body (12), the outer layer (112, 122) is located on each of plate surfaces, facing away from each other, of the first plate body (11) and the second plate body (12), and the cavity (13) is located between the inner layer (111, 121) of the first plate body (11) and the inner layer (111, 121) of the second plate body (12);
**characterized in that** the first plate body (11) and the second plate body (12) each are provided with a concave cavity structure, and after the first plate body (11) and the second plate body (12) are buckled to each other, the concave cavity structure located on the first plate body (11) and the concave cavity structure located on the second plate body (12) are buckled to each other to form the cavity (13).

2. The heat conducting part according to claim 1, wherein the inner layer (111, 121) is made of copper or copper alloy.

3. The heat conducting part according to claim 1 or 2, wherein the outer layer (112, 122) is made of at least one of aluminum, aluminum alloy, titanium, and titanium alloy.

4. The heat conducting part according to claim 3, wherein the first plate body (11) is provided with a groove recessed along a direction away from the second plate body (12); and/or the second plate body (12) is provided with a groove recessed along a direction away from the first plate body (11).

5. The heat conducting part according to claim 3 or 4, wherein at least one supporting column is disposed in the cavity (13); and
one end of the at least one supporting column is connected to the inner layer (111, 121) of the first plate body (11), and the other end of the at least one supporting column is connected to the inner layer (111, 121) of the second plate body (12).

6. The heat conducting part according to any one of claims 1 to 3, wherein at least one supporting column is disposed in the cavity (13); and
the two ends of the at least one supporting column are connected to the shell.

7. The heat conducting part according to claim 5 or 6, wherein the at least one supporting column is disposed close to a middle part of the cavity (13).

8. The heat conducting part according to any one of claims 5 to 7, wherein a locating slot is provided in an inner wall of the cavity (13); and
the two ends of the at least one supporting column abut against the locating slot.

9. The heat conducting part according to any one of claims 5 to 7, wherein the supporting column is a structure integrally formed with the shell.

10. The heat conducting part according to any one of claims 1 to 9, wherein the capillary structure is any one or a combination of a copper mesh, copper fiber, sintered copper powder, and a copper felt.

11. An electronic device, comprising a circuit board, an electric element installed on the circuit board, and the heat conducting part according to any one of claims 1 to 10, wherein
the heat conducting part is conductively connected to the electric element.

## Patentansprüche

1. Wärmeleitendes Teil, umfassend:
eine Hülle, umfassend eine Innenschicht (111, 121) und eine Außenschicht (112, 122), wobei ein Hohlraum (13) von der Innenschicht (111, 121) umschlossen ist und die Außenschicht (112, 122) eine Peripherie der Innenschicht (111, 121) umhüllt;
eine Kapillarstruktur, die im Hohlraum (13) angeordnet ist und an der Hülle anliegt; und
Kühlflüssigkeit, die sich im Hohlraum (13) befindet, wobei
die Innenschicht (111, 121) und die Außenschicht (112, 122) aus unterschiedlichen Materialien bestehen und eine Materialdichte der Außenschicht (112, 122) geringer als eine Materialdichte der Innenschicht (111, 121) ist;
wobei die Hülle einen ersten Plattenkörper (11) und einen zweiten Plattenkörper (12) umfasst, die zusammengefügt sind; und
die Innenschicht (111, 121) sich jeweils auf einander zugewandten Plattenoberflächen des ersten Plattenkörpers (11) und des zweiten Plattenkörpers (12) befindet, die Außenschicht (112, 122) sich jeweils auf von einander abgewandten Plattenoberflächen des ersten Plattenkörpers (11) und des zweiten Plattenkörpers (12) befindet und der Hohlraum (13) sich zwischen der Innenschicht (111, 121) des ersten Plattenkörpers (11) und der Innenschicht (111, 121) des zweiten Plattenkörpers (12) befindet;
**dadurch gekennzeichnet, dass** der erste Plattenkörper (11) und der zweite Plattenkörper (12) jeweils mit einer konkaven Hohlraumstruktur versehen sind, und nachdem der erste Plattenkörper (11) und der zweite Plattenkörper (12) zusammengefügt wurden, die konkave Hohlraumstruktur, die sich an dem ersten Plattenkörper (11) befindet, und die konkave Hohlraumstruktur, die sich an dem zweiten Plattenkörper (12) befindet, zusammengefügt sind, sodass sie den Hohlraum (13) bilden.

2. Wärmeleitteil nach Anspruch 1, wobei die Innenschicht (111, 121) aus Kupfer oder einer Kupferlegierung besteht.

3. Wärmeleitendes Teil nach Anspruch 1 oder 2, wobei die Außenschicht (112, 122) aus mindestens einem von Aluminium, Aluminiumlegierung, Titan und Titanlegierung besteht.

4. Wärmeleitendes Teil nach Anspruch 3, wobei der erste Plattenkörper (11) mit einer Nut versehen ist, die entlang einer Richtung weg vom zweiten Plattenkörper (12) vertieft ist; und/oder der zweite Plattenkörper (12) mit einer Nut versehen ist, die entlang einer Richtung weg vom ersten Plattenkörper (11) vertieft ist.

5. Wärmeleitendes Teil nach Anspruch 3 oder 4, wobei im Hohlraum (13) mindestens eine Stützsäule angeordnet ist; und
ein Ende der mindestens einen Stützsäule mit der Innenschicht (111, 121) des ersten Plattenkörpers (11) verbunden ist und das andere Ende der mindestens einen Stützsäule mit der Innenschicht (111, 121) des zweiten Plattenkörpers (12) verbunden ist.

6. Wärmeleitendes Teil nach Anspruch 1 oder 3, wobei im Hohlraum (13) mindestens eine Stützsäule angeordnet ist; und
die beiden Enden der mindestens einen Stützsäule mit der Hülle verbunden sind.

7. Wärmeleitendes Teil nach Anspruch 5 oder 6, wobei die mindestens eine Stützsäule nahe einem mittleren Teil des Hohlraums (13) angeordnet ist.

8. Wärmeleitendes Teil nach einem der Ansprüche 5 bis 7, wobei in einer Innenwand des Hohlraums (13) eine Aufnahmenut vorgesehen ist; und
die beiden Enden der mindestens einen Stützsäule an der Aufnahmenut anliegen.

9. Wärmeleitendes Teil nach einem der Ansprüche 5 bis 7, wobei die Stützsäule eine einstückig mit der Hülle gebildete Struktur ist.

10. Wärmeleitendes Teil nach einem der Ansprüche 1 bis 9, wobei die Kapillarstruktur eines von einem Kupfernetz, einer Kupferfaser, einem gesinterten Kupferpulver und einem Kupferfilz oder eine Kombination daraus ist.

11. Elektronische Vorrichtung, umfassend eine Leiterplatte, ein auf der Leiterplatte installiertes elektrisches Element und das wärmeleitende Teil nach einem der Ansprüche 1 bis 10, wobei
der wärmeleitende Teil leitend mit dem elektrischen Element verbunden ist.

## Revendications

1. Pièce thermoconductrice, comprenant :
une coque, comprenant une couche interne (111, 121) et une couche externe (112, 122), dans laquelle une cavité (13) est entourée par la couche interne (111, 121), et la couche externe (112, 122) enveloppe une périphérie de la couche interne (111, 121) ;
une structure capillaire, disposée dans la cavité (13) et venant en butée contre la coque ; et
un liquide de refroidissement, situé dans la cavité (13), dans laquelle
la couche interne (111, 121) et la couche externe (112, 122) sont constituées de matériaux différents, et une densité de matériau de la couche externe (112, 122) est inférieure à une densité de matériau de la couche interne (111, 121) ;
dans laquelle la coque comprend un premier corps de plaque (11) et un second corps de plaque (12) qui sont attachés l'un à l'autre ; et
la couche interne (111, 121) est située sur chacune des surfaces de plaque, tournées l'une vers l'autre, du premier corps de plaque (11) et du second corps de plaque (12), la couche externe (112, 122) est située sur chacune des surfaces de plaque, opposées l'une à l'autre, du premier corps de plaque (11) et du second corps de plaque (12), et la cavité (13) est située entre la couche interne (111, 121) du premier corps de plaque (11) et la couche interne (111, 121) du second corps de plaque (12) ;
**caractérisé en ce que** le premier corps de plaque (11) et le second corps de plaque (12) sont chacun pourvus d'une structure à cavité concave, et après que le premier corps de plaque (11) et le second corps de plaque (12) sont attachés l'un à l'autre, la structure à cavité concave située sur le premier corps de plaque (11) et la structure à cavité concave située sur le second corps de plaque (12) sont attachées l'une à l'autre pour former la cavité (13).

2. Pièce thermoconductrice selon la revendication 1, dans laquelle la couche interne (111, 121) est en cuivre ou en alliage de cuivre.

3. Pièce thermoconductrice selon la revendication 1 ou 2, dans laquelle la couche externe (112, 122) est constituée d'au moins l'un de l'aluminium, d'un alliage d'aluminium, du titane et d'un alliage de titane.

4. Pièce thermoconductrice selon la revendication 3, dans laquelle le premier corps de plaque (11) est pourvu d'une rainure évidée le long d'une direction s'éloignant du second corps de plaque (12) ; et/ou le second corps de plaque (12) est pourvu d'une rainure évidée le long d'une direction s'éloignant du premier corps de plaque (11).

5. Pièce thermoconductrice selon la revendication 3 ou 4, dans laquelle au moins une colonne de support est disposée dans la cavité (13) ; et
une extrémité de l'au moins une colonne de support est reliée à la couche interne (111, 121) du premier corps de plaque (11), et l'autre extrémité de l'au moins une colonne de support est reliée à la couche interne (111, 121) du second corps de plaque (12) .

6. Pièce thermoconductrice selon l'une quelconque des revendications 1 à 3, dans laquelle au moins une colonne de support est disposée dans la cavité (13) ; et
les deux extrémités de l'au moins une colonne de support sont reliées à la coque.

7. Pièce thermoconductrice selon la revendication 5 ou 6, dans laquelle l'au moins une colonne de support est disposée à proximité d'une partie médiane de la cavité (13).

8. Pièce thermoconductrice selon l'une quelconque des revendications 5 à 7, dans laquelle une fente de positionnement est pourvue dans une paroi interne de la cavité (13) ; et
les deux extrémités de l'au moins une colonne de support viennent en butée contre la fente de positionnement.

9. Pièce thermoconductrice selon l'une quelconque des revendications 5 à 7, dans laquelle la colonne de support est une structure formée d'un seul tenant avec la coque.

10. Pièce thermoconductrice selon l'une quelconque des revendications 1 à 9, dans laquelle la structure capillaire est l'une quelconque ou une combinaison d'un treillis de cuivre, d'une fibre de cuivre, d'une poudre de cuivre frittée et d'un feutre de cuivre.

11. Dispositif électronique, comprenant une carte de circuit imprimé, un élément électrique installé sur la carte de circuit imprimé et la pièce thermoconductrice selon l'une quelconque des revendications 1 à 10, dans lequel
la pièce thermoconductrice est connectée de manière conductrice à l'élément électrique.
